(19) Europäisches Patentamt

European Patent Office

Office européen des brevets

(11) **EP 0 545 498 B1**

(12) **EUROPÄISCHE PATENTSCHRIFT**

(45) Veröffentlichungstag und Bekanntmachung des
Hinweises auf die Patenterteilung:
**19.03.1997   Patentblatt 1997/12**

(51) Int Cl.6: **H03M 13/00**

(21) Anmeldenummer: **92203715.5**

(22) Anmeldetag: **01.12.1992**

(54) **Verfahren und Schaltungsanordnung zum Decodieren von RS-codierten Datensignalen**

Method and circuit for decoding RS-coded data signals

Procédé et circuit pour décoder des signaux codés en RS

(84) Benannte Vertragsstaaten:
**DE FR GB**

(30) Priorität: **04.12.1991   DE 4140018**

(43) Veröffentlichungstag der Anmeldung:
**09.06.1993   Patentblatt 1993/23**

(73) Patentinhaber:
- **Philips Broadcast Television Systems GmbH
  64347 Griesheim (DE)**
  Benannte Vertragsstaaten:
  **DE**
- **Philips Electronics N.V.
  5621 BA Eindhoven (NL)**
  Benannte Vertragsstaaten:
  **FR GB**

(72) Erfinder: **Mester, Roland
W-6100 Darmstadt (DE)**

(74) Vertreter: **von Laue, Hanns-Ulrich, Dipl.-Ing. et al
Philips Patentverwaltung GmbH,
Röntgenstrasse 24
22335 Hamburg (DE)**

(56) Entgegenhaltungen:
**EP-A- 0 295 949          WO-A-89/02123
DE-A- 3 838 234          US-A- 4 873 688**

## Beschreibung

Die Erfindung geht aus von einem Verfahren zum Decodieren von Reed-Solomon-(RS)-codierten Datensignalen nach dem Oberbegriff des Patentanspruchs 1.

Ein RS-Code ist ein systematischer Blockcode der Länge n, bei welchem k Informationssymbolen $(n - k) = p$ Checkworte zugesetzt werden. Durch den Codiervorgang werden Nachrichtensymbole nicht verändert. Der RS-Code hat eine minimale Hamming-Distanz $d = p + 1$ die bei einer Decodierung frei wählbar zur Fehlererkennung oder Fehlerkorrektur eingesetzt werden kann.

Bei einer Decodierung wird nicht zwischen Daten- und Checkworten unterschieden. Ein RS-Code-Block besteht aus n Symbolen, wobei für ein Symbol jede Bit-Anzahl $\geq 1$ möglich ist. Üblicherweise wird von einer Symbolbreite von 8 Bit ausgegangen. Für jeden Symbolfehler t werden bei einer Korrektur 2t Checkworte benötigt, um einen Fehlerort $X_i$ und einen Fehlerwert $Y_i$ zu berechnen. Ist das fehlerhafte Symbol als Auslöschung markiert, ist der Fehlerort $X_i$ bekannt. In diesem Fall wird zur Berechnung des Fehlerwertes $Y_i$ nur ein einziges Checkwort benötigt. Für RS-Codes gilt die Beziehung $2t + e \leq p = n - k = d - 1$, wobei mit e die Anzahl der Auslöschungen bezeichnet ist. In Zusammenhang mit der Aufzeichnung und Wiedergabe von Datensignalen auf/von Magnetband sind unter dem Begriff Auslöschungen Drop-Out-Störungen im wiedergegebenen Datensignal oder auch der Ausfall eines Datenübertragungskanals und einem damit begründeten Datensignalausfall zu verstehen. Weitere Einzelheiten zu RS-Codes sind der Zeitschrift 'IBM-Journal RES DEVELOP': "On-the-fly decoder for multiple byte errors", Vol. 30, NO.3, May 1986, Seiten 259 bis 269, zu entnehmen.

Prinzipiell wird ein RS-Code der Distanz d über das Code-Generator-Polynom

$$G(x) = \prod_{i=b}^{b+(d-2)} (x + \alpha^i)$$

definiert. Wesentlich ist, daß G(x) p aufeinanderfolgende Nullstellen enthält.

Bei vielen RS-Codes wir b=0 gesetzt, b kann aber auch eine beliebige Konstante kleiner $2^m$ sein. So ist beispielsweise in dem sogenannten D1-Standard (Standard for Recording Digital Television Signals on Magnetic Tape in Cassettes; European Broadcast Union; Tech 3252-E) ein Code-Generator-Polynom beginnend mit b = 0; entsprechend

$$G(x) = (x + \alpha^0)(x + \alpha^1) \ldots (x + \alpha^{15})$$

festgelegt und in einem ISO-Standard ein Code-Generator-Polynom beginnend mit b = 120; entsprechend

$$G(x) = (x + \alpha^{120})(x + \alpha^{121}) \ldots (x + \alpha^{135}).$$

Beide Code-Generator-Polynome unterscheiden sich lediglich durch einen konstanten Versatz im Exponenten von $\alpha$.

Aus dem Tagungsband 'IEEE 1990 Custom Integrated Circuits Conference': "A 40 MHz Endoder/Decoder Chip generated by a Reed-Solomon Code Compiler", Seiten 13.5.1 bis 13.5.4, CH2860-5/90/0000-0065, ist bereits eine Schaltungsanordnung zum Decodieren von RS-codierten Daten bekannt. Hier werden zunächst in einer ersten Stufe von den empfangenen Datenworten einer Übertragungsstrecke Syndrome berechnet. In einer nachgeschalteten zweiten Stufe werden von den berechneten Syndromen nach einem Euclid-Algorithmus Fehlerort- und Fehlerwert-Polynome berechnet, die anschließend in einer dritten Stufe einer Nullstellen-Suche nach Chien unterworfen werden. Mit den auf diese Weise ermittelten Fehlerorten und Fehlerwerten wird in einer vierten Stufe durch eine EXOR-Verknüpfung die eigentliche Korrektur der anliegenden Daten durchgeführt. Diese bekannte Schaltungsanordnung kann jedoch nur ein nach dem Code-Generator-Polynom

$$G(x) = (x + \alpha^0)(x + \alpha^1) \ldots (x + \alpha^{15})$$

erzeugtes Datensignal decodieren.

Der vorliegenden Erfindung liegt die Aufgabe zugrunde, ein Verfahren und eine Schaltungsanordnung nach der eingangs genannten Art anzugeben, um mit hoher Datenrate ( >100 MBit/s ) vorliegende Datensignale, welche nach dem Code-Generator-Polynom

$$G(x) = (x + \alpha^0) \, (x + \alpha^1) \, ... \, (x + \alpha^{15})$$

oder

$$G(x) = (x + \alpha^{120}) \, (x + \alpha^{121}) \, ... \, (x + \alpha^{135})$$

codiert sein können, echtzeitfähig zu decodieren.

Diese Aufgabe wird durch die im kennzeichnenden Teil der Patentansprüche 1 und 2 angegebenen Merkmale gelöst.

Eine nach dem erfindungsgemäße Verfahren ausgeführte Schaltungsanordnung weist den Vorteil auf, daß in einer einzigen Anordnung wahlweise RS-codierte Datensignale, die nach zwei unterschiedlichen Code-Generator-Polynomen codiert sein können, decodiert werden, wobei der Aufwand für zusätzliche Schaltungselemente gering bleibt.

Durch die in den Unteransprüchen aufgeführten Maßnahmen sind vorteilhafte Weiterbildungen und Verbesserungen der im Patentanspruch 1 angegebenen Schaltungsanordnung möglich.

Ein Ausführungsbeispiel der Erfindung ist in der Zeichnung dargestellt und in der nachfolgenden Beschreibung näher erläutert. Es zeigen:

Fig. 1    ein grobes Blockschaltbild eines bekannten RS-Decoders,

Fig. 2    ein Blockschaltbild einer Einrichtung zum Bilden von Syndromen und Bestimmen von Auslöschorten in einem RS-codierten Datensignal,

Fig. 3    das grobe Blockschaltbild einer Einrichtung zum Berechnen von Fehlerort- und Fehlerwert-Polynomen nach einem Euclid-Algorithmus,

Fig. 4    ein Blockschaltbild einer Einrichtung zur Ermittlung von Fehlerorten und Fehlerwerten durch eine Nullstellensuche nach Chien,

Fig. 5    ein Blockschaltbild einer Einrichtung zur Korrektur der RS-codierten Datensignale,

Fig. 6    Tabellen zur konstanten Multiplikation mit $\alpha^0$ bis $\alpha^{15}$ und

Fig. 7    Tabellen zur konstanten Multiplikation mit $\alpha^{120}$ bis $\alpha^{135}$.

Definitionsgemäß ist bei RS-Codes jedes Symbol mit m-Bits das Element eines Galois-Feldes $GF(2^m)$. Die Sequenz der $2^m$ Symbole als Basis der finiten Feld-Arithmetik wird durch das Feldgeneratorpolynom p(x) definiert. Die Symbolbreite beschränkt die maximale Blocklänge eines RS-Codes von $2^m$-1, da die Elemente des Feldes als eindeutige Positionszahl im Block benötigt werden. Darin ist eine Null ein neutrales Element bezüglich der Addition und ein Ausdruck $\alpha^0$=1 ein neutrales Element einer Multiplikation. Ein Feld wird somit über ein irreduzibles Feldgeneratorpolynom definiert. Wird ein primitives Element $\alpha$ der Stellenzahl m definiert, können alle folgenden Elemente als Potenz von $\alpha$ ausgedrückt werden. Da $\alpha$ eine Wurzel von p(x) ist, und da ferner nur m Wurzeln ungleich Null existieren, gilt p(x)=0 für alle weiteren Elemente. Das Galois-Feld läßt sich somit als endliche Folge von $2^m$-1 Elementen definieren. Dabei ermöglicht die binäre Komponenten-Darstellung eine einfache Addition über eine Bit-weise EXOR-Verknüpfung und eine Exponentendarstellung eine einfache Multiplikation über eine Addition der Exponenten modulo $q = 2^m$-1. Dies entspricht in einer Schaltungsumsetzung einem binären Addierer, dessen Übertragsausgang mit einem Übertragseingang verbunden ist.

Wie eingangs bereits erwähnt, ist ein RS-Code allgemein über das Code-Generator-Polynom

$$G(x) = \prod_{i=b}^{b+(d-2)} (x + \alpha^i)$$

definiert.

Ein legaler Codevektor c(x) entsteht durch Division eines um p Stellen verschobenen Informations-Vektors $i(x) \cdot x^p$ durch G(x) und Anhängen des dabei entstehenden Paritäts-Vektors p(x) in den freigewordenen Stellen des Informations-Vektors i(x). Der resultierende Code-Vektor c(x) ist dabei durch alle Wurzeln von G(x) ohne Rest teilbar. Die einzelnen Polynome und Vektoren lassen sich wie folgt darstellen:

| | |
|---|---|
| $i(x) = i_{k-1}x^{k-1} + i_{k-2}x^{k-2} + ... + i_1x^1 + i_0$ | Informations-Polynom |
| $p(x) = (i(x) * x^p) \bmod G(x)$ | Paritäts-Polynom |
| $c(x) = (i(x) * x^p) + p(x)$ | Code-Polynom |
| $c_i = (i_{k-1}, i_{k-2}, .., i_1, i_0, P_{p-1}, P_{p-2}, .., p_1, p_0)$ $= (c_{n-1}, c_{n-2}, ..., c_1, c_0)$ | Code-Vektor = gesendeter Vektor |
| $e_i = (e_{n-1}, e_{n-2}, ..., e_1, e_0)$ | Fehler-Vektor |
| $u_i = (u_{n-1}, u_{n-2}, ..., u_1, u_0)$ | Auslöschungs-Vektor |
| $r_1 = c_i + e_i + u_i$ | empfangener Vektor |

Der Fehler-Vektor $e_i$ ist an maximal t Stellen ungleich Null, ansonsten gleich Null. Entsprechendes gilt für den Auslöschungs-Vektor $u_i$, der an maximal e Stellen ungleich Null ist. Bei Überschneidungen von $e_i$ und $u_i$ an gleichen Positionen werden Fehler zu Auslöschungen.

Ein übertragener RS-codierter Codeblock $c(x)$ besteht aus k Informationsstellen, denen p Checkworte folgen. Durch diese Codekonstruktion ist gewährleistet, daß $c(x)$ durch alle Wurzeln durch $G(x)$ ohne Rest teilbar ist, solange kein Fehler $e(x)$ oder Auslöschungen $u(x)$ auftreten. Die Entwicklung eines Empfangsvektors $r(x)$ an den Wurzeln des Code-Generator-Polynoms $G(x)$ erzeugt Werte, die von empfangenen Fehlern abhängig sind, jedoch nicht von der übertragenen Information $i(x)$. Diese Werte werden als Syndrome bezeichnet. Die m Syndrome $S_j$ ($j=0 ... d-2$) werden nach der Gleichung

$$S_{b+j} = \sum_{i=0}^{n-1} r_i(\alpha^{i*(b+j)}) = \sum_{k=0}^{e+t-1} Y_k(X_k)^{(b+j)}$$

berechnet.

Der empfangene Vektor (x) läßt sich in einer Polynom-Darstellung wie folgt beschreiben:

$$r(x) = r_{n-1}x^{n-1} + r_{n-2}x^{n-2} + ... + r_1x^1 + r_0$$

Dabei bezeichnet x eine Position im Polynom für jedes empfangene Symbol $r_i$. Das erste empfangene (Daten-) Symbol ist $r_{n-1}$, das letzte (Paritäts-) Symbol $r_0$. Zur Speicherung des Polynoms müssen nur die Koeffizienten $r_i$ abgelegt werden.

Da die Entwicklung eines fehlerfreien Empfangsvektors $r(x)$ an einer Nullstelle des Codegenerator-Polynoms den Wert Null liefert, sind die Werte der Syndrome als Summen der positionsgewichteten Fehler $Y_k$ an den Stellen $X_k$ zu betrachten. Die Syndrome stellen dabei Reste einer Division des Datenstroms $r(x)$ durch alle Faktoren $(x+\alpha^i)$ des Codegeneratorpolynoms dar, wobei

$$S_j = \sum_{k=0}^{e+t-1} Y_k(X_k)^j$$

(für alle Syndrome $S_0...S_{d-2}$ im Fall $b=0$) ist.

Wird bei einer Auslöschung die Position eines Auftretens $X_k$ festgehalten, so läßt sich mit p Syndromen und p Fehlerorten $X_k$ bis zu $e = p$ Auslöschungen berechnen, so lange $2t + e \leq p$ ist, wobei t die Anzahl nicht markierten Fehler ist.

Die Syndrome bilden nach der zuvor genannten Gleichung einen Satz von p nichtlinearen Gleichungen, so daß p Lösungen ermittelt werden können. Die Lösungen des Gleichungssystems sind Koeffizienten eines Fehlerortpolynoms, welches an den Fehlerorten den Wert Null aufweist.

Eine Decodierung von RS-codierten Datenblöcken nach dem erwähnten Euclid-Algorithmus ist in der Zeitschrift 'IEEE Proceedings': "Simplified procedure for correcting both errors and erasures of RS code using Euclid algorithm", Vol. 135, Pt.E, No. 6, Nov. 1988, by Truong Eastman Reed HSU, angegeben. Der Euclid-Algorithmus läßt sich in folgende Schritte gliedern:

1. Berechnung der Syndrome $S_j$ sowie des Polynoms von Auslöschungsorten L(x) und dem Setzen von e=deg {L(x)}.

2. Berechnung eines sogenannten Forney-Syndroms

$$\tau(x) = S(x)L(X) \bmod x^{d-1}$$

3. Für e = d-1 = p wird T(x) = L(x) und R(x) = $\tau(x)$ gesetzt. Anderenfalls wird T(x) und R(x) durch Anwendung eines Euclid-Algorithmus bestimmt. Der Euclid-Algorithmus besteht aus folgenden rekursiven Formeln:

$$T_s(x) = (Q_{s-1}(x))T_{s-1}(x) + T_{s-2}(x)$$

$$R_s(x) = (Q_{s-1}(x))R_{s-1}(x) + R_{s-2}(x)$$

$$Q_{s-1}(x) = R_{s-2}(x)/R_{s-1}(x),$$

mit den Anfangswerten:
$T_o(x)=L(x)$, $T_{-1}(x)=O$, $R_{-1}(x)=x^{d-1}$, $R_0(x)=\tau(x)$. Darin ist $T_s(x)$ ein Fehlerortpolynom, $R_s(x)$ ein Fehlerwertpolynom und $Q_{s-1}(x)$ ein Zwischenwertpolynom. Danach kann $R_s(x)$ und $T_s(x)$ mit dem niedrigsten Koeffizienten $T_s(0) = \delta$ normiert werden, wobei $R(x)=R_s(x)/\delta$ und $T(x)=T_s(x)/\delta$ ist. R(x) und T(x) sind die Ergebnisse des Euclid-Algorithmus, wenn der Grad $R_s <= \lfloor_{(d + e - 3)}/s\rfloor$ ist, wobei $\lfloor$ und $\rfloor$ einen ganzzahligen Anteil bezeichnen.

Die Wurzeln von T(x) sind inverse (rückwärts gezählte) Orte von Fehlern und Auslöschungen $X_k^{-1}$. Die einzelnen Fehlerorte $X_k^{-1}$ werden in dem vorliegenden Ausführungsbeispiel durch eine Nullstellensuche nach Chien gefunden. Gleichzeitig werden bei diesem Vorgang die Fehlerwerte $Y_k$ bestimmt mittels der Beziehung:

$$Y_k = \frac{R(X_k)}{X_k^{\ b} * T'(X_k)}$$

Dabei ist $T'(X_k)$ die erste Ableitung von T an der Stelle $X_k$. In endlichen Feldern werden die Ableitungen von Polynomen gebildet, wobei n-faches Addieren für gerade n Null ergibt und für ungerade n das Element selbst. Durch diese Maßnahme wird somit der gesuchte Fehlerort und der entsprechende Fehlerwert bestimmt.

In den Figuren sind gleiche Teile mit gleichen Bezugszeichen versehen.

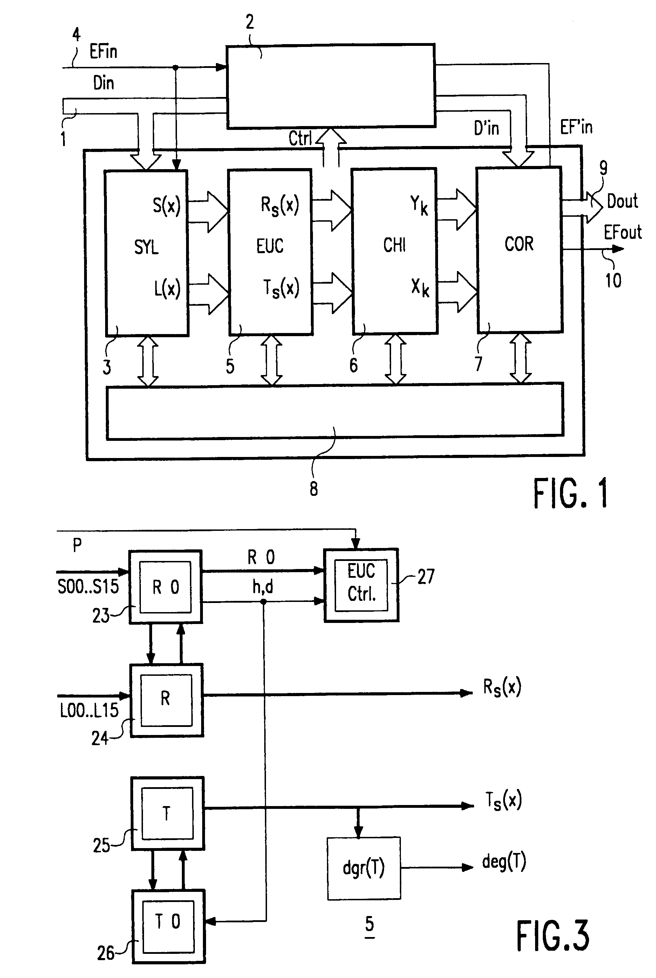

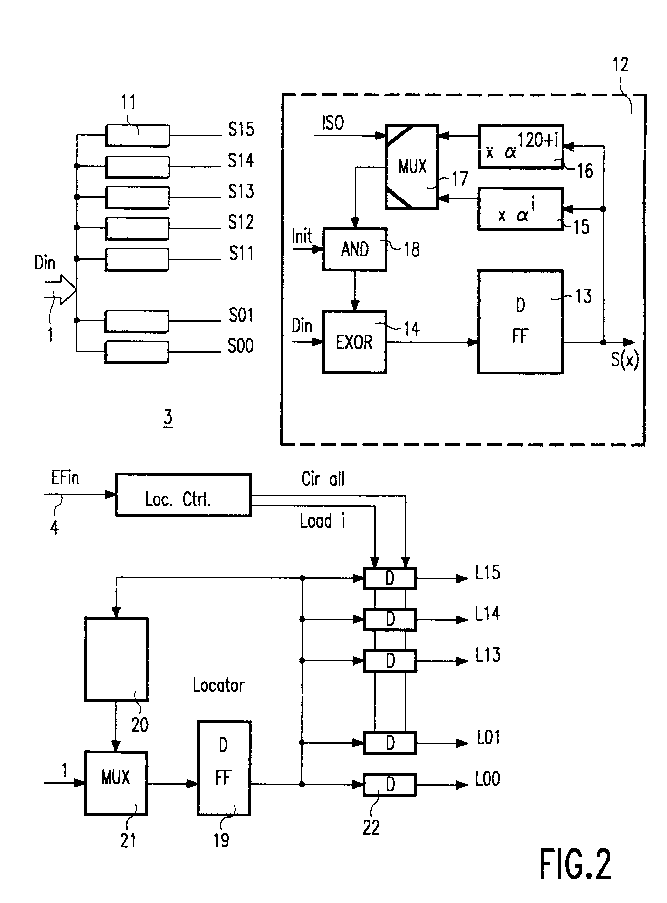

Die Figur 1 zeigt das grobe Blockschaltbild eines RS-Decoders. Darin ist mit 1 ein Datenbus bezeichnet, über welchem 8 Bit breite Datenworte $D_{in}$ des RS-codierten Datensignals zum einen einer Verzögerungseinrichtung 2 zum Ausgleich von Signallaufzeiten und zum anderen einem Funktionsblock 3, der im wesentlichen zur Bildung von Syndromen S(x) und zur Bestimmung von Auslöschorten L(x) dient, zugeführt werden. Parallel zu dem RS-codierten Datensignal wird in der Verzögerungseinrichtung 2 ein 1 Bit breites Fehlersignal $EF_{in}$ verzögert, daß von einem (nicht dargestellten) Drop-Out-Detektor oder einer vorausgehenden Fehlererkennungsstufe abgegeben sein kann. Das Fehlersignal $EF_{in}$ wird auch dem Funktionsblock 3 zugeführt. Einzelheiten zu dem Funktionsblock 3 sind in Zusammenhang mit der Fig. 2 angegeben.

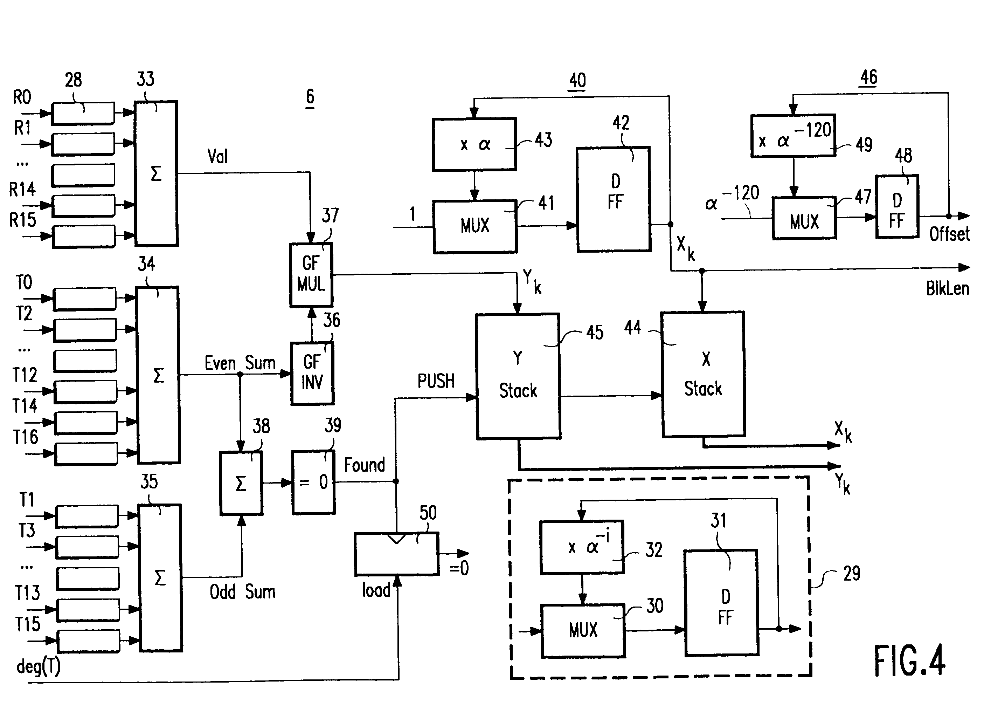

Die in dem Funktionsblock 3 abgeleiteten Syndrome S(x) und Auslöschorte L(x) werden zu einem Funktionsblock 5 weitergeleitet, der zur Berechnung eines Euclid-Algorithmus vorgesehen ist, um ein Fehlerortpolynom T(x) und ein Fehlerwertpolynom R(x) zu erzeugen. Weitere Angaben zu dem Funktionsblock 5 sind der nachfolgenden Beschreibung zu der Fig. 3 zu entnehmen.

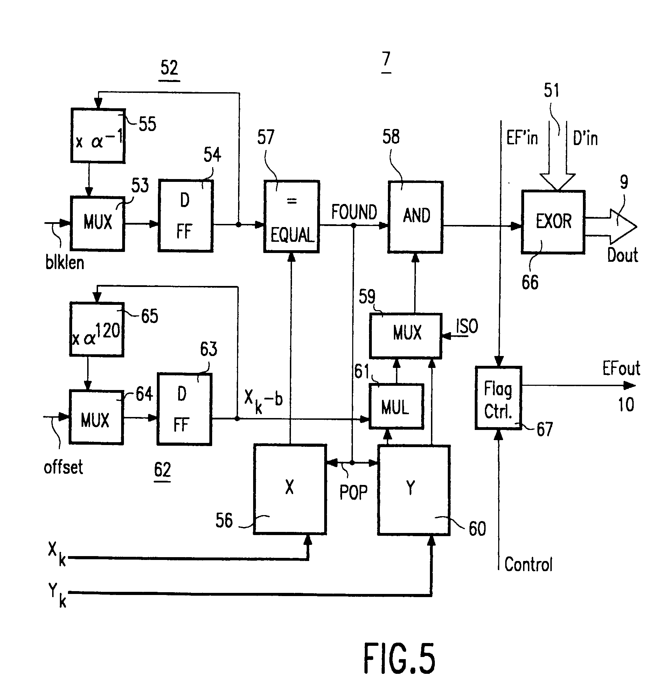

In nachgeschalteten Funktionsblöcken 6 und 7, die in Zusammenhang mit den Figuren 4 und 5 ausführlicher beschrieben sind, werden die Nullstellen der Polynome $T_s(x)$ und $R_s(x)$ bestimmt und mit den erhaltenen Fehlerwerten $Y_k$ und den Fehlerorten $X_k$ die Korrektur fehlerhafter Datenworte durchgeführt, die zusammen mit dem Fehlersignal vom Ausgang der Verzögerungseinrichtung 2 dem Funktionsblock 7 zugeführt werden. Die Steuerung der vier Funktionsblöcke 3 bis 7 sowie der Verzögerungseinrichtung 2 erfolgt durch eine Steuereinrichtung 8. Am Ausgang des Funktionsblockes 7 ist auf einem Datenbus 9 ein Datenstrom mit 8 Bit breiten Datenworten $D_{out}$ abnehmbar, von denen im Rahmen der Korrekturfähigkeit der Decoderanordnung fehlerhafte Datenworte korrigiert sind. Solche Datenblöcke, die die Korrekturfähigkeit der Decoderanordnung überschreiten, werden durch ein Fehlersignal $EF_{out}$ gekennzeichnet, welches parallel mit den über den Datenbus 9 abgegebenen Daten auf einer Leitung 10 übertragen wird.

Bei dem in der Fig. 2 dargestellten Blockschaltbild des Funktionsblockes 3 werden mit sechzehn Syndromgeneratoren 11 von dem anliegenden Datensignal $D_{in}$ die Syndrome $S_{00}$ bis $S_{15}$ berechnet. Einer der sechzehn Syndromgeneratoren 11 ist in einem gestrichelt umrahmt gezeichneten Block 12 ausführlicher dargestellt. Ein Syndromgenerator besteht danach im wesentlichen aus einer rückgekoppelten Registeranordnung 13, welche über EXOR-Gatter 14 mit dem Datensignal $D_{in}$ angesteuert wird. In einem Rückkopplungszweig der Registeranordnung 13 befinden sich zwei Multiplizierer 16 und 15, deren Eingänge mit einem Ausgang der Registeranordnung 13 verbunden sind. Der Multiplizierer 15 dient zum Multiplizieren mit $\alpha^i$ und der Multiplizierer 16 zum Multiplizieren mit $\alpha^{120+i}$.

Die beiden Multiplizierer 15 und 16 können in an sich bekannter Weise (EP-Patentschrift 0 147 041 B1) mit EXOR-Gattern aufgebaut sein. In diesem Fall werden 8 Bit breit anliegende Datenworte entsprechend dem Exponenten i des Ausdrucks $\alpha^i$ in einer bestimmten Weise Exklusiv-ODER-verknüpft. So werden beispielsweise bei $\alpha^1$ die auf 8 Leitungen der 8 Bit parallel übertragenen Datenworte so EXOR-Verknüpft, daß

| Ausgangsleitung | 0 | mit | Eingangsleitung | 7 | | |
|---|---|---|---|---|---|---|
| " | 1 | " | " | 0 | | |
| " | 2 | " | " | 7 | EXOR Eingangsltg. | 1 |
| " | 3 | " | " | 7 | " | 2 |
| " | 4 | " | " | 7 | " | 3 |
| " | 5 | " | " | 4 | | |
| " | 6 | " | " | 5 | | |
| " | 7 | " | " | 8 | | |

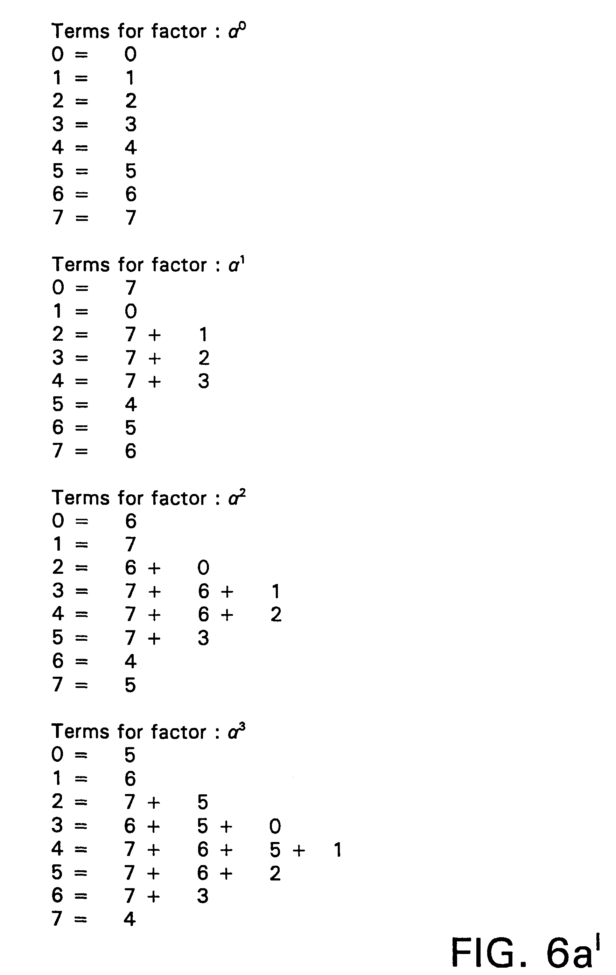

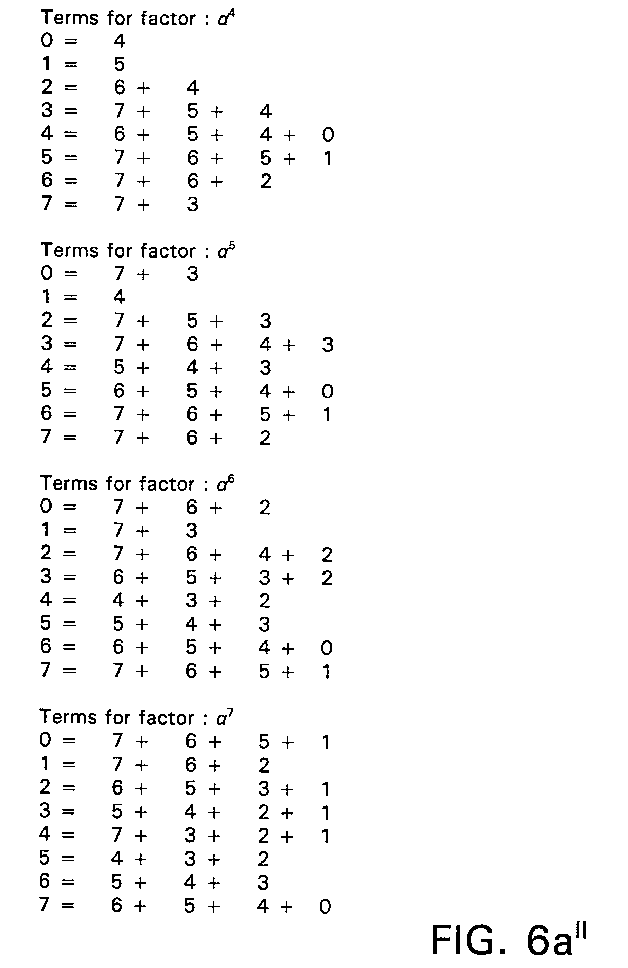

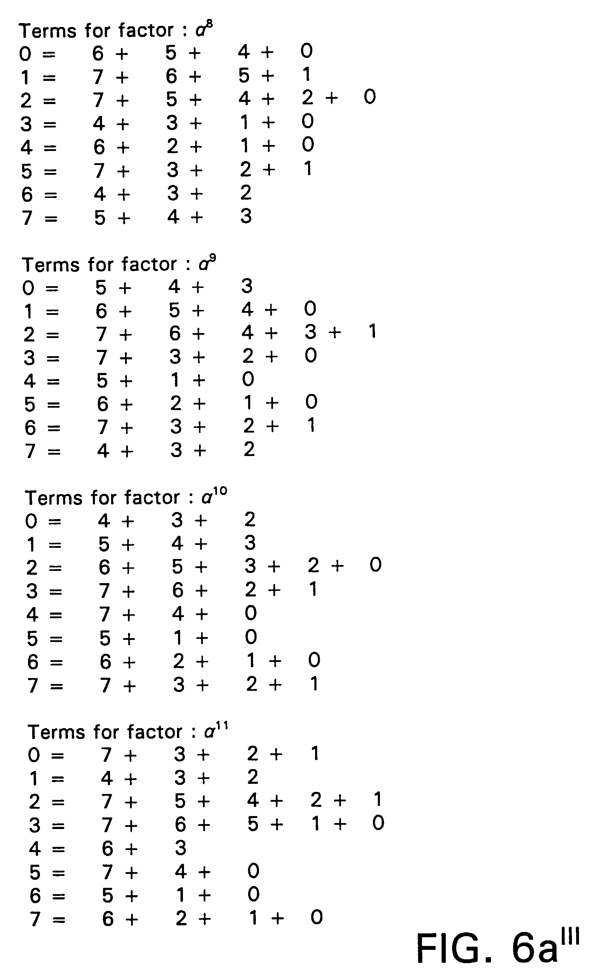

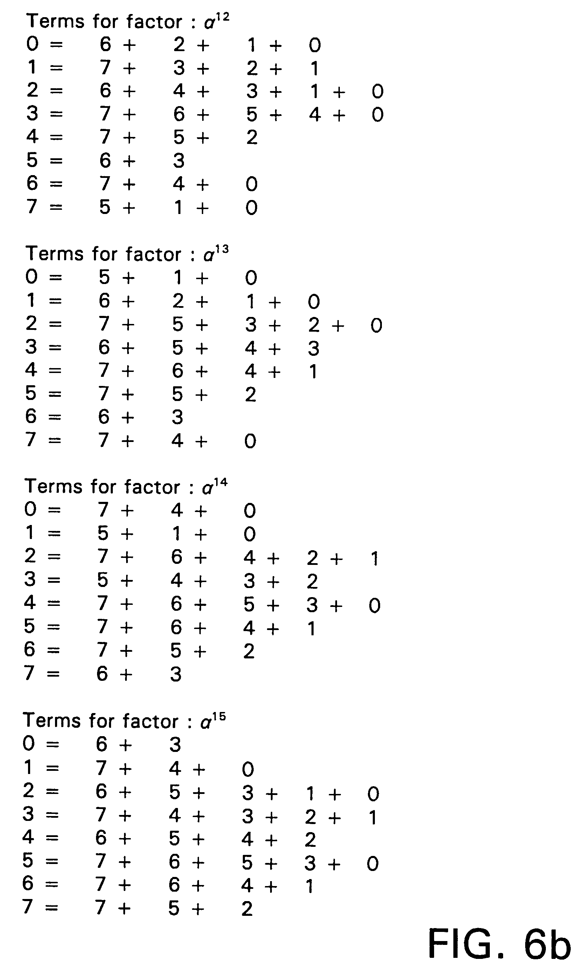

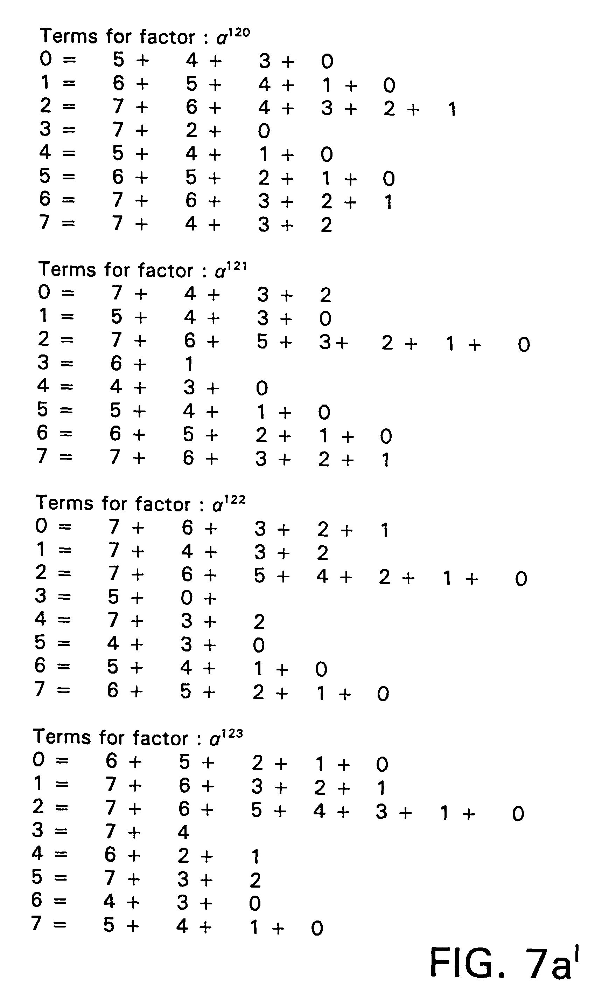

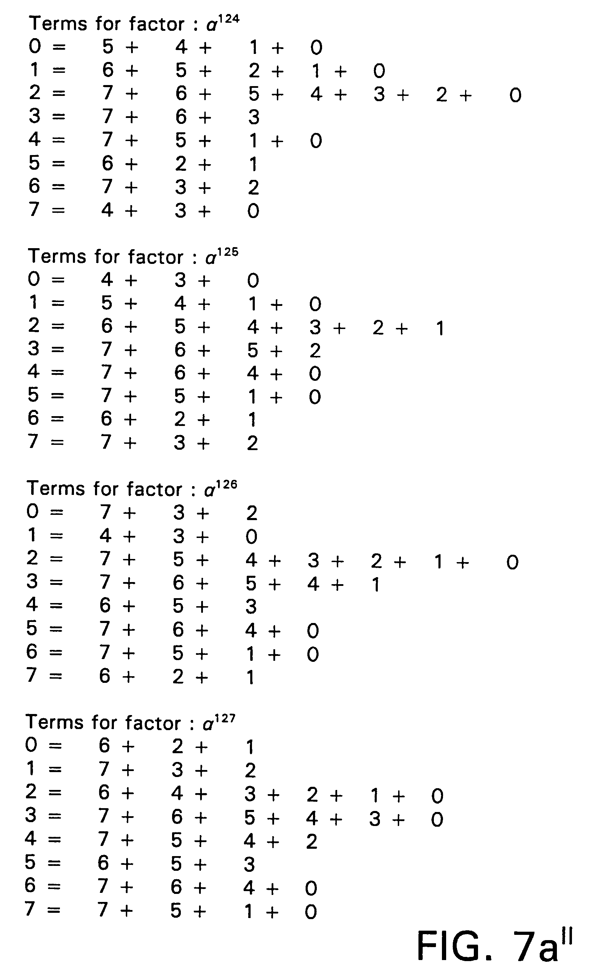

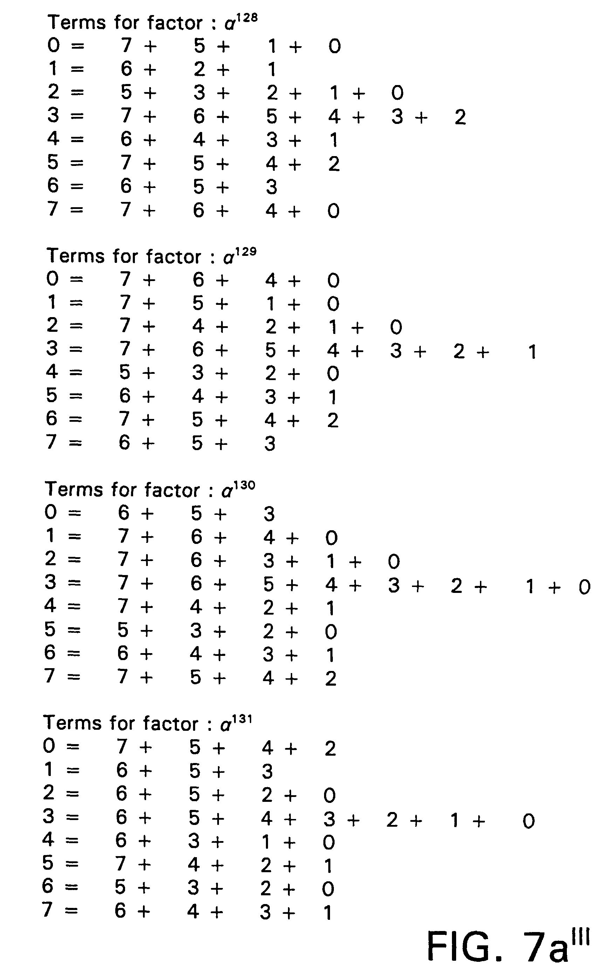

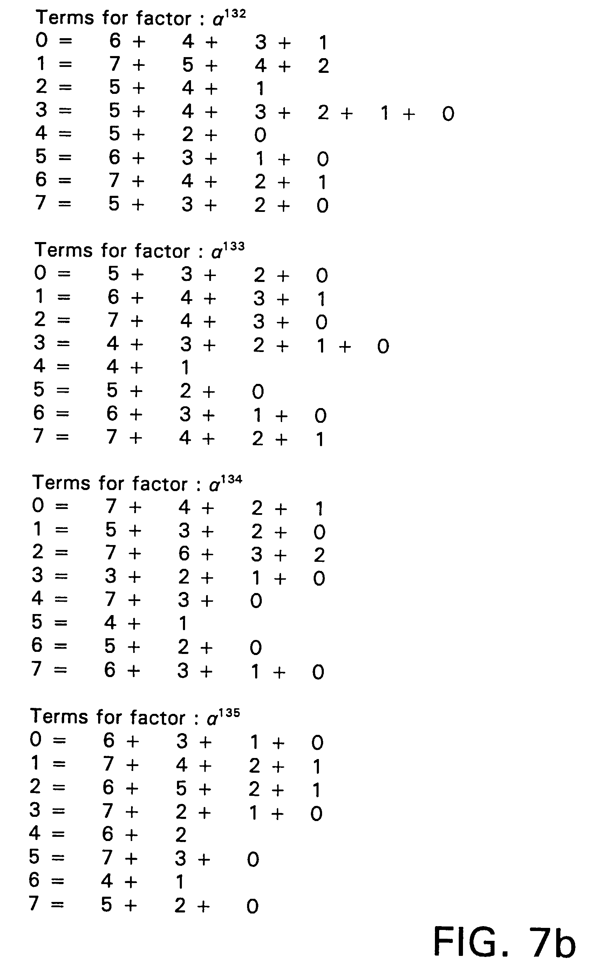

verbunden ist. In den Figuren 6a und 6b sind die einzelnen EXOR-Verknüpfungen des Multiplizierers 15 für $\alpha^0$, $\alpha^1$ ... $\alpha^{15}$ angegeben und in den Figuren 7a und 7b die des Multiplizierers 16 für $\alpha^{120}$, $\alpha^{121}$ bis $\alpha^{135}$.

Die an den Ausgängen der Multiplizierer 15 und 16 erhaltenen Ergebnisse können wahlweise mit einem Multiplizierer 17 abgegriffen und über ein UND-Gatter 18 auf einen Eingang der EXOR-Gatter 14 gekoppelt werden. Bei der Decodierung des Code-Generator-Polynoms

$$G(x) = (x + \alpha^{120})(x + \alpha^{121}) ... (x + \alpha^{135})$$

schaltet der von einem Steuersignal ISO gesteuerte Multiplexer 17 das von dem Multiplizierer 16 erzeugte Ergebnis zu den EXOR-Gattern 14 durch. Soll dagegen ein Code-Generator-Polynom

$$G(x) = (x + \alpha^0)(x + \alpha^1) ... (x + \alpha^{15})$$

decodiert werden, so wird von dem Multiplexer 16 das am Ausgang des Multiplizierers 15 erhaltene Ergebnis zu den EXOR-Gattern 14 weitergeleitet.

Die Syndromgeneratoren $S_i$ (i = 0 bis 15), bilden den Rest einer Division $c(x)/(x + \alpha^i)$. Die Syndromgeneratoren werden dabei jeweils zu Blockbeginn initiiert, indem die Rückkopplung über das UND-Gatter aufgetrennt wird. In dem vorliegenden Takt werden die Syndrome $S(x)$ des letzten Blocks zu dem Funktionsblock 5 weitergeleitet, in welchem Auslöschungen nach dem erwähnten Euclid-Algorithmus bestimmt werden. Außerdem werden in dem Funktionsblock 3 Auslöschungsorte $L(x)$ ermittelt. Dazu zählt ein Generator alle Positionen in einem Datenblock durch. Dieser Generator besteht aus einem D-Register 19, das über einen Multiplizierer 20 sowie einem Multiplexer 21 rückgekoppelt ist. Bei dem Auftreten einer Auslöschung wird der Ort in einem freien Register 22 gespeichert, die die Auslöschorte L00 bis L 15 ausgeben. Auch diese Register sind zu Blockbeginn mit dem Wert Null gesetzt. Wenn mehrere Auslöschungen auftreten als durch eine Korrektur-Begrenzung vorgegeben ist, wird $L(x)$ Null gesetzt. In diesem Fall kann nachfolgend eine begrenzte Korrektur von Fehlern versucht werden.

Der in der Fig. 1 mit 5 bezeichnete Funktionsblock ist in der Fig. 3 als grobes Blockschaltbild ausführlicher dargestellt. Das Blockschaltbild umfaßt zwei sechzehn Bit breite Register 23 und 24. Dem Register 23 werden die von den Syndromgeneratoren 11 erzeugten Syndrome S00 bis S15 zugeführt. An Eingängen des Registers 24 liegen die von den Registern 22 ausgegebenen Löschorte L00 bis L15. Außerdem umfaßt das Blockschaltbild zwei siebzehn Bit breite Register 25 und 26, die mit konstanten Anfangswerten 0 bzw. 1 geladen werden. Zur Berechnung der Fehlerortpoly-

nome $T_s(x)$ und den Fehlerwertpolynom $R_s(x)$ nach dem eingangs erwähnten Euclid-Algorithmus können die Inhalte der Register 23 und 24 sowie 25 und 26 auch vertauscht werden. Die Steuerung der Register 23 bis 26 erfolgt mit Hilfe einer Steuerung 27 über den Grad von R0. Am Ende der an sich bekannten Berechnung der Fehlerortpolynome $T_s(x)$ und der Fehlerwertpolynome $R_x(x)$, die prinzipiell auch aus der Zeitschrift IEEE 1990 Custom Integrated Circuits of Conference, S. 13.5.1 bis 13.5.4 bekannt ist, wird ein Signal deg(T) abgeleitet, daß den Grad von T anzeigt und damit angibt, wieviel Fehler in einem Datenblock für eine nachfolgende Suche nach Chien erwartet werden können.

Der in der Figur 1 dargestellte Funktionsblock 6 ist in der Figur 4 ausführlicher dargestellt. Die von dem Funktionsblock 5 abgegebenen Polynome werden in dem vorliegenden Ausführungsbeispiel dreiunddreizig Einheiten eines zyklischen Decoders 28 zugeführt. Das Blockschaltbild einer Einheit des zyklischen Decoders 28 ist in dem strichpunktiert umrahmten Block 29 näher dargestellt. Danach werden zu Blockbeginn die anliegenden Signale der Polynome über einen Multiplexer 30 in ein Register 31 geladen. Sodann wird fortlaufend jedes Element $R_i$ bzw. $T_i$ zyklisch mit den in einem Block 32 zur Verfügung gestellten Symbolen $\alpha^{-i}$ multipliziert. Ist auf diese Weise eine Nullstelle T(x) gefunden, d.h. die Summe aller $T_i = 0$, so kann der Fehlerwert berechnet werden als $Y_k = R(x_k)/T'(x_k)$ für den Fall b = 0.

Die Ableitung T'(x) ergibt entsprechend den Rechenregeln im Galois-Feld das Polynom der geraden Koeffizienten von T. Derartige zyklische Decoder sind aus der eingangs erwähnten Zeitschrift IBM-Journal RES DEVELOP, Vol. 30, NO. 3, May 1986, Seiten 259 bis 269, bekannt.

Die von den einzelnen zyklischen Decodern abgegebenen Signale werden in Addierstufen 33, 34 und 35 zusammengefaßt. Die Summen Val, Even Sum und Odd Sum am Ausgang der Addierstufen 33 bis 35 sind ein EXOR über alle Bits einer Ebene. Im vorliegenden Fall wird beispielsweise Bit 0 von der Summe Val über ein 16-fach-EXOR der Bits 0 von R0 ... R15 gebildet. Eine Division $R(x_k)/T'(x_k)$ wird als Multiplikation mit der Inversen ausgeführt. Dieser Rechenvorgang erfolgt in einer Galois-Feld-Invertierstufe 36 und in einer Galois-Feld-Multiplizierstufe 37. Die Summe VAL entspricht dabei $R(x_k)$, während die Summe Even Sum $T'(x_k)$ entspricht. Die auf eine Multiplikation zurückgeführte Division liefert am Ausgang der Galois-Feld-Multiplizierstufe 37 den gewünschten Fehlerwert $Y_k$.

Die Summen Even Sum und Odd Sum werden in einer Addierstufe 38 zusammengeführt; eine Nullabfrage erfolgt in einer Stufe 39. Weist das Signal 'Found' am Ausgang der Stufe 39 einen high-Pegel auf, so wird zugleich mit dem gefundenen Fehlerwert $Y_k$ der Wert eines Positionszählers 40, der aus einem Multiplexer 41, einem Register 42 und einem Multiplizierer 43 besteht, auf dem Stapel eines Stapelspeichers 44 für Werte von Fehlerorten $X_k$ abgelegt. Dazu sei angenommen, daß der bzw. die Stapelspeicher aus Registern 0 bis XVI bestehen. Das Ablegen auf dem Stapel des Stapelspeichers 44 erfolgt in einem Register 0, während die bisherigen Werte der von Registern 0 bis XIV jeweils um eine Position auf Register I bis XV aufrücken. Dabei geht der Inhalt von Register XV verloren. Der Stapel erfüllt die Funktion eines sogenannten LIFO's (Last In/First Out), da der Suchalgorithmus nach Chien inverse Fehlerorte in rückwärtiger Reihenfolge berechnet. Parallel zu dem Stapelspeicher 44 wird ein Stapelspeicher 45 betrieben, welcher die Fehlerwerte $Y_i$ speichert.

Das Blockschaltbild der Einrichtung 6 zur Ermittlung von Fehlerorten $X_k$ und Fehlerwerten $Y_K$ weist ferner einen inversen Zähler 46 auf, der ebenfalls einen Multiplexer 47, ein Register 48 und einen Multiplizierer 49 enthält. Im Gegensatz zu dem Positionszähler 40 wird jedoch das rückgekoppelt angeordnete Register 48 bei Beginn eines Datenblocks mit dem Wert $\alpha^{-120}$ geladen. Die am Ausgang des Registers 48 vorliegenden Datenwerte (Offset) werden in dem Multiplizierer 49 fortlaufend mit $\alpha^{-120}$ multipliziert.

Weiterhin enthält das Blockschaltbild der Fig. 4 einen Zähler 50, der mit dem Wert des Signals deg(T) geladen wird und durch Anlegen des von der Stufe 39 abgegebenen Signals 'Found' zurückgestellt wird. Bleibt der Zähler am Ende eines Datenblockdurchlaufs bei dem Wert 0 stehen, so ist dies eine Gewähr dafür, daß der Grad des Polynoms T (Grad = 1 + Index des höchsten Koeffizienten ungleich 0), der eine Aussage über die Anzahl der zu erwartenden Fehler liefert, mit dem tatsächlich gefundenen Nullstellen in einem Datenblock übereinstimmt und damit die Decodierung erfolgreich verlaufen ist. Anderenfalls liegt ein unkorrigierbarer Fehler vor.

Nach n Takten eines Datenblocks werden die in den Stapelspeichern 44 und 45 gesammelten Fehlerorte $X_k$ und Fehlerwerte $Y_k$ parallel zu der Einrichtung 7 transferiert, so daß die Einrichtung 6 initialisiert werden kann und anschließend für eine erneute Suche nach Chien zur Verfügung steht.

Die Fig. 5 zeigt ein Blockschaltbild der Einrichtung 7 zur Korrektur der am Ausgang der Verzögerungseinrichtung 2 abgegebenen, laufzeitangepaßten Datensignale, die bei 51 zugeführt werden.

In diesem Blockschaltbild wird mit Hilfe eines inversen Positionszählers 52 die Reihenfolge der Werte $X_k$ und $Y_k$ umgekehrt. Dieser inverse Positionszähler 52 besteht aus einem Multiplizierer 53, einem Register 54 und einer Stufe 55. Die Anordnung ist so getroffen, daß am Blockanfang das Register 54 über den Multiplexer 53 mit dem Endwert der Blocklänge 'blklen' geladen wird. Die Ausgangswerte des Registers 54 werden während der übrigen Zeit über die Stufe 55 mit Werten der Symbole $\alpha^{-1}$ rückgekoppelt und damit multipliziert. Ein Fehlerort $X_k$ ist dann gefunden, wenn die von dem inversen Positionszähler 52 abgegebenen Daten identisch mit dem Inhalt eines Registers 0 und eines Stapelspeichers 56 ist, der die Fehlerorte $X_k$ enthält. Der Vergleich wird in einer Vergleichsstufe 57 durchgeführt, die ein entsprechendes Ausgangssignal 'Found' abgibt. Dieses Signal 'Found' stellt ein Torimpulssignal für ein UND-Gatter 58 dar, das mit einem anderen Eingang über einen Multiplexer 59 mit einem Ausgang eines Stapelspeichers 60 verbunden ist, in welchem die Fehlerwerte $Y_k$ des Stapelspeichers 45 transferiert worden sind, wenn b = 0 ist und damit ein Datensignal des Code-Generator-Polynoms

$$G(x) = (x + \alpha^0)\,(x + \alpha^1) \ldots (x + \alpha^{15})$$

decodiert werden soll.

Soll dagegen das Datensignal eines Code-Generator-Polynoms

$$G(x) = (x + \alpha^{120})\,(x + \alpha^{121}) \ldots (x + \alpha^{135})$$

decodiert werden (b = 120), so wird der andere Eingang des UND-Gatters 58 über den Multiplexer 59 mit dem Ausgang eines Multiplizierers 61 verbunden, dessen Eingang mit einem Ausgang des Stapelspeichers 60 und mit einem Ausgang eines weiteren Vorwärtszählers 62 verbunden ist. Ähnlich den zuvorbeschriebenen Zählern weist auch der Zähler 62 zunächst ein rückgekoppeltes Register 63 auf, in welches das von dem inversen Zähler 46 erzeugte Signal 'Offset' über einen Multiplexer 64 geladen wird. Ein im Rückkopplungszweig des Registers 63 angeordneter Multiplizierer 65 multipliziert die Ausgangswerte des Registers 63 beginnend mit dem Wert $\alpha^{120}$. Die derart gefundenen Faktoren $x_k^{-b}$ werden zur Korrektur der im Stapelspeicher 60 abgelegten Fehlerwerte $Y_k$ herangezogen. Am Ausgang des Multiplizierers 61 liegt somit ein an das Code-Generator-Polynom

$$G(x) = (x + \alpha^{120})\,(x + \alpha^{121}) \ldots (x + \alpha^{135})$$

angepaßter korrigierter Fehlerwert $Y_k$, der dem Ausdruck

$$Y_k = \frac{R(x_k)}{x_k^b \ast T'(x_k)} = \frac{R(x_k)}{T'(x_k)} \ast x_k^{-b}$$

genügt.

Das am Ausgang der Vergleichsstufe 57 abgegebene Signal 'Found' dient auch zur Steuerung der beiden Stapelspeicher 56 und 60. Liegt in dem Signal 'Found' ein logischer high-Pegel vor, wird der oberste Wert in dem Stapelspeicher 56 entfernt. Das bedeutet, daß in den Stapelspeichern 56 und 60 befindliche Register I bis XV auf die Registerpositionen 0 bis XIV kopiert werden und das Register XV eine logische Null nachzieht. Sind alle Fehler korrigiert, liegt eine logische Null auf dem Stapel. In diesem Fall kann keine weitere Koinzidenz mit dem inversen Positionszähler 52 auftreten.

Der am Ausgang des UND-Gatters 58 vorliegende Fehlerwert $Y_k$ wird mit dem in der Verzögerungseinrichtung 2 verzögerten Datenwert Din in einer EXOR-Stufe 66 logisch verknüpft: es wird die eigentliche Fehlerkorrektur durchgeführt. An dem Ausgang 9 wird das fehlerkorrigierte Datensignal Dout ausgegeben. Das ebenfalls von der Verzögerungseinrichtung 2 verzögerte Fehlersignal EFin gelangt abhängig von der Steuereinrichtung 8 des RS-Decoders über eine Stufe 67 zu dem Ausgangsbus 10.

Die Decodierung von RS-codierten Datensignalen für die beiden Code-Generator-Polynome erfolgt in der vorliegenden Schaltungsanordnung im wesentlichen zweistufig. Dabei wird in einer ersten Stufe zunächst der Fehlerwert $Y_k$ für Datensignale des Code-Generator-Polynoms

$$G(x) = (x + \alpha^0)\,(x + \alpha^1) \ldots (x + \alpha^{15})$$

ermittelt und mit dem ermittelten Fehlerwert die Fehlerkorrektur durchgeführt. Im Fall der Decodierung von Datensignalen eines Code-Generator-Polynoms

$$G(x) = (x + \alpha^{120})\,(x + \alpha^{121}) \ldots (x + \alpha^{135})$$

wird der in der ersten Stufe ermittelte Fehlerwert $Y_k$ lediglich durch einen parallel, in einer zweiten Stufe abgeleiteten Faktor $x_k^{-b}$ korrigiert. Diese Zweistufigkeit der Signalverarbeitung weist den Vorteil auf, daß eine kontinuierliche Arbeitsgeschwindigkeit von etwa 20 MHz (160 MBit/s) für 8 Bit breite Datenworten erzielt werden kann. Dabei kann während der Decodierung von Datenblock zu Datenblock auf das eine oder andere Code-Generator-Polynom umgeschaltet werden. Ein weiterer Vorteil ist, daß die erfindungsgemäße Schaltungsanordnung keine aufwendigen Divisionsschaltungen zur Berechnung der Fehlerwerte $Y_k$ benötigt. Die vorliegende Schaltungsanordnung ist insbesondere geeignet, Fehler in von Magnetband wiedergegebenen RS-codierten Datensignalen zu erkennen und zu korrigieren. Auslöschungen im wiedergegebenen Datensignal können aufgrund der besonderen Struktur der erfindungsgemäßen Schaltungsanordnung auch ignoriert werden, um beispielsweise eine Korrektur der nicht markierten Fehler zu versuchen. Darüber hinaus besteht die Möglichkeit, die der erfindungsgemäßen Schaltungsanordnung innewohnende Fehlerkorrekturfähigkeit zugunsten einer Fehlererkennungssicherheit zu reduzieren, um so größere, ohnehin nicht korrigierbare Bündelfehler in einer nachgeschalteten Einrichtung Fehler zu verdecken.

**Patentansprüche**

1. Verfahren zum Decodieren von RS-codierten Datensignalen, welche nach einem Code-Generator-Polynom

$$G(x) = (x + \alpha^{0+b}) \, (x + \alpha^{1+b}) \ldots (x + \alpha^{15+b})$$

codiert sind,

bei welchem Syndrome (S(x)) und Auslöschorte (L(x)) der RS-codierten Datensignale ermittelt werden,
bei welchem von den ermittelten Syndromen (S(x)) und Auslöschorten durch Anwendung eines Eulic-Algorth-mus ein Fehlerortpolynom $T_s(x)$ und ein Fehlerwertpolynom $R_s(x)$ abgeleitet wird,
bei welchem Fehlerorte $x_k$ und Fehlerwerte $Y_k$ durch eine Nullstellensuche nach Chien mit der Beziehung

$$Y_k = \frac{R(X_k)}{X_k^{\,b} * T'(X_k)}$$

ermittelt werden, wobei $T'(X_k)$ die erste Ableitung an einer Stelle $x_k$ ist, und
bei welchem Datenworte im RS-codierten Datensignal anhand der ermittelten Fehlerorte $X_k$ und Fehlerwerte $Y_k$ korrigiert werden,

**dadurch gekennzeichnet**,

- daß die Syndrome (S(x)) von Fehlerorten $X_k$ und Fehlerwerten $Y_k$ nach dem Code-Generator-Polynom

$$G(x) = (x + \alpha^{0+b}) \, (x + \alpha^{1+b}) \ldots (x + \alpha^{15+b})$$

ermittelt werden,
- daß bei einer Dekodierung von RS-codierten Datensignalen des Code-Generator-Polynom

$$G(x) = (x + \alpha^{0}) \, (x + \alpha^{1}) \ldots (x + \alpha^{15})$$

die ermittelten Fehlerwerte $Y_k$ direkt zur Fehlerkorrektur herangezogen werden und
- daß bei einer Dekodierung von RS-codierten Datensignalen eines Code-Generator-Polynoms mit b ungleich Null die für das Code-Generator-Polynom

$$G(x) = (x + \alpha^{0}) \, (x + \alpha^{1}) \ldots (x + \alpha^{15})$$

ermittelten Fehlerwerte $Y_k$ mit dem Faktor $X_k^b$ beaufschlagt werden, bevor eine Fehlerkorrektur der RS-codierten Datensignale durchgeführt wird.

2. Schaltungsanordnung zur Durchführung des Verfahrens nach Anspruch 1, mit

einer Einrichtung (3) zum datenblockweise Bilden von Syndromen (S(x)) sowie zum Bestimmen von Auslöschorten (L(x)) in den RS-codierten Datensignalen,
einer Einrichtung (5) zur Anwendung eines Euclid-Algorithmus, bei welchem

$$T_s(x) = (Q_{s-1}(x))T_{s-1}(x)+T_{s-2}(x),$$

$$R_s(x) = (Q_{s-1}(x))R_{s-1}(x)+R_{s-2}(x)$$

und

$$Q_{s-1}(x) = R_{s-2}(x)/R_{s-1}(x)$$

ist,
wobei $T_s(x)$ ein Fehlerortpolynom, $R_s(x)$ ein Fehlerwertpolynom und $Q_{s-1}(x)$ ein Zwischenwertpolynom ist,
eine Einrichtung (6) zur Ermittlung von Fehlerorten $x_k$ und Fehlerwerten $Y_k$ durch eine Nullstellensuche nach Chien mit der Beziehung:

$$Y_k = \frac{R(X_k)}{X_k^{\ b} * T'(X_k)} ,$$

wobei $T'(X_k)$ die erste Ableitung an einer Stelle $x_k$ ist, und
eine Einrichtung (7) zur Korrektur von Datenworten innerhalb eines anliegenden RS-codierten Datenblocks anhand der ermittelten Fehlerorte $X_k$ und Fehlerwerte $Y_k$,

**gekennzeichnet durch**
in der Einrichtung (3) zur Bestimmung der Syndrome (S(x)) angeordnete Syndromgeneratoren (11), bestehend jeweils aus

- ersten EXOR-Stufen (14), deren einen Eingängen Datenworte der RS-codierten Datensignale Bit-parallel zugeführt sind,
- Registern (13) zur Speicherung der von den ersten EXOR-Stufen (14) abgegebenen Datenworte,
- einem ersten Multiplizierer (15) zur Multiplizierung der am Ausgang der Register (13) vorliegenden Datenworte mit einer Konstanten $\alpha^i$, wobei i eine Laufvariable von 0 bis 15 ist,
- einem zweiten Multiplizierer (16) zur Multiplizierung der am Ausgang der Register (13) vorliegenden Datenworte mit einer Konstanten $a^{i+120}$,
- einem ersten Multiplexer (17), welcher bei einer Decodierung RS-codierter Datensignale nach einem mit $\alpha^0$ beginnenden Code-Generator-Polynom, die an einem Ausgang des ersten Multiplizierers (15) abnehmbaren Daten zu anderen Eingängen der ersten EXOR-Stufen (14) weiterleitet und welcher bei der Decodierung RS-codierter Datensignale nach einem mit $\alpha^{120}$ beginnenden Code-Generator-Polynom die an einem Ausgang des zweiten Multiplizierers (16) abnehmbaren Daten zu den anderen Eingängen der EXOR-Stufen (14) weiterleitet,

in der Einrichtung (6) zur Ermittlung von Fehlerorten $X_k$ und Fehlerwerten $Y_k$ vorgesehene

- Vorwärtszähler (40) zum Vorwärtszählen der in einem Datenblock befindlichen Datenworte und zur Abgabe eines Zielwertes (x) bei dem Ermitteln einer Nullstelle nach Chien, sowie jeweils einen
- ersten Stapelspeicher (44), in welchem die von dem Vorwärtszähler (40) abgegebenen Zählwerte (x) einschreibbar sind,
- zweiten Stapelspeicher (56), in welchem am Ende eines jeden Datenblocks aus dem ersten Stapelspeicher (44) gelesene Daten einschreibbar sind,
- dritten Stapelspeicher (45), in welchem zeitgleich mit dem jeweiligen Einschreiben der Zählwerte ($x_k$) in den ersten Stapelspeicher (44) die Fehlerwerte ($Y_k$) einschreibbar sind,
- vierten Stapelspeicher (60), in welchem am Ende eines Datenblocks aus dem dritten Stapelspeicher (45) gelesene Daten einschreibbar sind, und

- parallel zum Vorwärtszähler (40) betriebenen inversen Zähler (46), welcher gegenüber dem Vorwärtszähler (40) einen Offset von $\alpha^{-120}$ aufweist,

in der Einrichtung (7) zur Korrektur von Datenworten jeweils enthaltenen

- Rückwärtszähler (52) zum Rückwärtszählen, beginnend mit dem Wert einer Datenblocklänge,
- Anordnung (57) zum Vergleichen des jeweils an einer obersten Stelle in dem zweiten Stapelspeicher (56) vorliegenden Zählwertes mit den vom Rückwärtszähler (52) abgegebenen Zählwerten zur Ableitung eines Steuersignals (Found) bei Gleichheit der anliegenden Werte,
- UND Gatter (58), dessen einer Eingang mit einem Ausgang der Vergleichsanordnung (57) verbunden ist,
- von dem inversen Zähler (46) angesteuerten weiteren zweiten Vorwärtszähler (62), welcher einen Offset von 120 aufweist,
- dritten Multiplizierer (61) zur Multiplikation der an einer obersten Stelle in dem vierten Stapelspeicher (60) vorliegenden Fehlerwert ($X_k$) mit dem von dem weiteren zweiten Vorwärtszähler (62) abgegebenen Zählwert,
- zweiten Multiplexer (59), welcher bei einer Decodierung RS-codierter Daten Signale nach einem mit $\alpha^0$ beginnenden Code-Generator-Polynom den an einer obersten Stelle in dem vierten Stapelspeicher (60) vorliegenden Fehlerwert ($X_k$) zu einem anderen Eingang des UND-Gatters (58) weiterleitet und welcher bei einer Decodierung RS-codierter Datensignale nach einem mit $\alpha^{120}$ beginnenden Code-Generator-Polynom dem am Ausgang des zweiten Multiplizierers (59) vorliegenden Wert $Y_k$ zu dem anderen Eingang des UND-Gatters (58) weiterleitet,
- zweiten EXOR-Stufen (66), deren ersten Eingänge das an Ausgängen der UND-Gatter (58) abnehmbaren Signale, deren zweite Eingänge Signallaufzeit angepaßte Datenworte der RS-codierten Datensignale Bit-parallel zugeführt sind und an deren Ausgang fehlerkorrigierte Datenworte abnehmbar sind.

3. Schaltungsanordnung nach Anspruch 2, dadurch gekennzeichnet, daß der Vorwärtszähler (40) eine drittte Multiplexerstufe (41) mit einem nachgeschalteten zweiten Register (42) aufweist, bei welchem zu Blockbeginn einem Eingang der dritten Multiplexerstufe (41) der Wert $\alpha^0=1$ zugeführt ist und bei welchem während der übrigen Zeit an einem anderen Eingang der Multiplexerstufe (41) mit einem Wert $\alpha^i$ multiplizierte Werte der von dem Register (42) abgegebenen Ausgangswerte liegen.

4. Schaltungsanordnung nach Anspruch 2, dadurch gekennzeichnet, daß der Rückwärtszähler (52) eine vierte Multiplexerstufe (53) mit einem nachgeschalteten Register (54) aufweist, bei welchem zu Blockbeginn einem Eingang der vierten Multiplexerstufe (53) der Wert einer Blocklänge zugeführt ist und bei welchem während der übrigen Zeit an einem anderen Eingang der vierten Multiplexerstufe (53) die von dem nachgeschalteten Register (54) abgegebenen Ausgangswerte liegen.

5. Schaltungsanordnung nach Anspruch 2, dadurch gekennzeichnet, daß der inverse Zähler (46) eine fünfte Multiplexerstufe (47) mit einem weiteren nachgeschalteten Register (48) aufweist, welchem über die fünfte Multiplexerstufe (47) bei Blockbeginn ein Wert $\alpha = -120$ und während der übrigen Zeit ein am Ausgang des weiteren nachgeschalteten Registers (48) vorliegender Wert, der in einer Multiplizierstufe (49) mit $\alpha^{120}$ multipliziert wird, zugeführt ist.

6. Schaltungsanordnung nach Anspruch 2 und 5, dadurch gekennzeichnet, daß der weitere Vorwärtszähler (62) eine vierte Multiplizierstufe (65) mit einem nachgeschalteten fünften Register (63) aufweist, welchem über die vierte Multiplizierstufe (65) bei Blockbeginn ein am Ausgang des vierten Registers (48) liegender Wert und während der übrigen Zeit ein am Ausgang des fünften Registers (63) vorliegender Wert, der in der vierten Multiplizierstufe (65) mit $\alpha^{120}$ multipliziert wird, zugeführt ist.

7. Schaltungsanordnung nach Anspruch 2 bis 6, dadurch gekennzeichnet, daß jede der Multiplizierstufen zum Multiplizieren von Werten mit einem Faktor $\alpha^{i+b}$, wobei i = 0 bis 15 und b = 120 oder 0 ist, als EXOR-Verknüpfung ausgeführt ist.

**Claims**

1. A method of decoding RS-coded data signals coded in accordance with a code generator polynomial

$$G(x) = (x+\alpha^{0+b})\,(x+\alpha^{1+b}) \ldots (x+\alpha^{15+b})$$

in which syndromes (S(x)) and erasure locations (L(x)) of the RS-coded data signals are determined,
in which an error location polynomial $T_s(x)$ and an error value polynomial $R_s(x)$ are derived from the determined syndromes (S(x)) and erasure locations by using a Euclid's algorithm,
in which error locations $x_k$ and error values $Y_k$ are determined by means of a Chien zero search defined by the expression

$$Y_k = \frac{R(X_k)}{X_k^{\,b} * T'(X_k)}$$

in which $T'(X_k)$ is the first derivative at a position $x_k$, and
in which data words in the RS-coded data signal are corrected with reference to the determined error locations $X_k$ and error values $Y_k$,

characterized in that

- the syndromes (S(x)) of error locations $X_k$ and error values $Y_k$ in accordance with the code generator polynomial

$$G(x) = (x+\alpha^{0+b})\,(x+\alpha^{1+b}) \ldots (x+\alpha^{15+b})$$

are determined,
- the determined error values $Y_k$ are directly used for error correction when decoding RS-coded data signals of the code generator polynomial

$$G(x) = (x+\alpha^{0})\,(x+\alpha^{1}) \ldots (x+\alpha^{15}),$$

and
- the factor $X_k^b$ is applied to the error values $Y_k$ determined for the code generator polynomial

$$G(x) = (x+\alpha^{0})\,(x+\alpha^{1}) \ldots (x+\alpha^{15})$$

when RS-coded data signals of a code generator polynomial with b being unequal to zero are decoded, before an error correction of the RS-coded data signals is performed.

2. A circuit arrangement for performing the method as claimed in Claim 1, comprising

a device (3) for forming syndromes (S(x)) for successive data blocks and for determining erasure locations (L(x)) in the RS-coded data signals,
a device (5) for using a Euclid's algorithm in which

$$T_s(x) = Q_{s-1}(x)T_{s-1}(x)+T_{s-2}(x)$$

$$R_s(x) = Q_{s-1}(x))R_{s-1}(x)+R_{s-2}(x)$$

and

$$Q_{s-1}(x) = R_{s-2}(x)/R_{s-1}(x),$$

in which $T_s(x)$ is an error location polynomial, $R_s(x)$ is an error value polynomial and $Q_{s-1}(x)$ is an intermediate value polynomial,
a device (6) for determining error locations $x_k$ and error values $Y_k$ by means of a Chien zero search defined by the relation:

$$Y_k = \frac{R(X_k)}{X_k{}^b * T'(X_k)} \, ,$$

in which $T'(X_k)$ is the first derivative at a location $x_k$ and
a device (7) for correcting data words within an RS-coded data block on the basis of the determined error locations $X_k$ and error values $Y_k$,

characterized by syndrome generators (11) arranged in the device (3) for determining syndromes (S(x)), each generator comprising

- first exclusive-OR stages (14) to whose inputs data words of the RS-coded data signals are bit-parallel applied,
- registers (13) for storing the data words supplied by the first exclusive-OR stages (14),
- a first multiplier (15) for multiplying the data words present at the output of the register (13) by a constant $\alpha^i$, in which i is a control variable from 0 to 15,
- a second multiplier (16) for multiplying the data words present at the output of the register (13) by a constant $a^{i+120}$,
- a first multiplexer (17) which passes on the data from an output of the first multiplier (15) to other inputs of the first exclusive-OR stages (14) when RS-coded data signals in accordance with a code generator polynomial starting with $\alpha^0$ are decoded and which passes on the data from an output of the second multiplier (16) to the other inputs of the exclusive-OR stages (14) when RS-coded data signals in accordance with a code generator polynomial starting with $\alpha^{120}$ are decoded,

the device (6) for determining error locations $X_k$ and error values $Y_k$ comprising

- an up-counter (40) for up-counting the data words present in a data block and for supplying a counting value (x) for the Chien zero search, and
- a first stack memory (44) in which the counting values (x) supplied by the up-counter (40) can be written,
- a second stack memory (56) in which data read from the first stack memory (44) can be written at the end of each data block,
- a third stack memory (45) in which the error values ($Y_k$) can be written simultaneously when the counting values ($x_k$) are written in the first stack memory (44),
- a fourth stack memory (60) in which data read from the third stack memory (45) can be written at the end of a data block, and
- an inverse counter (46) operated parallel to the up-counter (40) and having an offset of $\alpha^{-120}$ with respect to the up-counter (40),

the device (7) for correcting data words comprising

- a down-counter (52) for down-counting, starting with the value of a data block length,
- an arrangement (57) for comparing the counting value present at an upper position in the second stack memory (56) with the counting values supplied by the down-counter (52) for deriving a control signal (Found) when the values provided are equal,
- an AND gate (58), one input of which is connected to an output of the comparison arrangement (57),
- a further second up-counter (62) controlled by the inverse counter (46) and having an offset of 120,
- a third multiplier (61) for multiplying the error value ($X_k$) present at an upper position in the fourth stack memory (60) by the counting value supplied by the further second up-counter (62),
- a second multiplexer (59) which passes on the error value ($X_k$) present at an upper position in the fourth stack memory (60) to another input of the AND gate (58) when RS-coded data signals in accordance with a code generator polynomial starting with $\alpha^0$ are decoded and which passes on the value $Y_k$ present at the output of the second multiplier (59) to the other input of the AND gate (58) when RS-coded data signals in accordance with a code generator polynomial starting with $\alpha^{120}$ are decoded,
- second exclusive-OR stages (66) whose first inputs receive the signal which can be derived from outputs of the AND gate (58), whose second inputs receive bit-parallel signal delay-adapted data words of the RS-coded data signals and from whose output error-corrected data words can be derived.

3. A circuit arrangement as claimed in Claim 2, characterized in that the up-counter (40) comprises a third multiplexer stage (41) preceding a second register (42), in which an input of the third multiplexer stage (41) receives the value $\alpha^0 = 1$ at the start of a block and in which, during the remaining period, another input of the multiplexer stage (41) conveys values, multiplied by a value $\alpha^i$, of the output values supplied by said register (42).

4. A circuit arrangement as claimed in Claim 2, characterized in that the down-counter (52) comprises a fourth multiplexer stage (53) preceding a register (54), in which an input of the fourth multiplexer stage (53) receives a block length value at the start of a block and in which, during the remaining period, another input of the fourth multiplexer stage (53) conveys the output values supplied by said register (54).

5. A circuit arrangement as claimed in Claim 2, characterized in that the inverse counter (46) comprises a fifth multiplexer stage (47) preceding a further register (48) which receives a value $\alpha^{-120}$ *via* the fifth multiplexer stage (47) at the start of the block and, during the remaining period, receives a value present at the output of said register (48), which value is multiplied by $\alpha^{120}$ in a multiplier stage (49).

6. A circuit arrangement as claimed in Claims 2 and 5, characterized in that the further up-counter (62) comprises a fourth multiplier stage (65) preceding a fifth register (63) which receives a value present at the output of the fourth register (48) *via* the fourth multiplier stage (65) at the start of a block and, during the remaining period, receives a value present at the output of said fifth register (63), which value is multiplied by $\alpha^{120}$ in the fourth multiplier stage (65).

7. A circuit arrangement as claimed in Claims 2 to 6, characterized in that each multiplier stage is formed as an exclusive-OR gate for multiplying values by a factor of $\alpha^{i+b}$, in which i = 0 to 15 and b = 120 or 0.

**Revendications**

1. Procédé pour décoder des signaux de données codés en RS, qui sont codés suivant un polynôme générateur de code

$$G(x) = (x + \alpha^{0+b}) (x + \alpha^{1+b}) \dots (x + \alpha^{15+b}),$$

dans lequel des syndromes (S(x)) et des positions d'effacements (L(x)) des signaux de données codés en RS sont déterminés,
dans lequel un polynôme de positions d'erreurs $T_s(x)$ et un polynôme de valeurs d'erreurs $R_s(x)$ sont dérivés des syndromes (S(x)) et des positions d'effacements déterminés au moyen d'un algorithme d'Euclide,
dans lequel des positions d'erreurs $x_k$ et des valeurs d'erreurs $Y_k$ sont déterminées par une recherche de positions zéros de Chien par la relation :

$$Y_k = \frac{R(X_k)}{X_k^b * T'(X_k)}$$

où $T'(X_k)$ est la dérivée première dans une position $x_k$, et
dans lequel des mots de données dans le signal de données codé en RS sont corrigés à l'aide des positions d'erreurs $X_k$ et des valeurs d'erreurs $Y_k$ déterminées,

caractérisé en ce que

- les syndromes (S(x)) sont déterminés à partir des positions d'erreurs $X_k$ et des valeurs d'erreurs $Y_k$ suivant le polynôme générateur de code

$$G(x) = (x + \alpha^{0+b}) (x + \alpha^{1+b}) \dots (x + \alpha^{15+b}),$$

- lors d'un décodage de signaux de données codés en RS du polynôme générateur de code

$$G(x) = (x + \alpha^0) \, (x + \alpha^1) \, ... \, (x + \alpha^{15}),$$

les valeurs d'erreurs déterminées $Y_k$ sont directement utilisées pour la correction d'erreurs, et
- lors d'un décodage de signaux de données codés en RS d'un polynôme générateur de code avec b non nul, les valeurs d'erreurs $Y_k$ déterminées pour le polynôme générateur de code $G(x) = (x + \alpha^0) \, (x + \alpha^1) \, ... \, (x + \alpha^{15})$ sont chargées du facteur $X_k{}^b$, avant qu'une correction d'erreurs des signaux de données codés en RS soit réalisée.

2. Montage de circuit pour exécuter le procédé suivant la revendication 1, comportant

un dispositif (3) pour former à la manière de blocs de données des syndromes $(S(x))$ ainsi que pour déterminer des positions d'effacements $(L(x))$ dans les signaux de données codés en RS,
un dispositif (5) pour l'utilisation d'un algorithme d'Euclide, dans lequel

$$T_s \, (x) = (Q_{s-1}(x))T_{s-1}(x) + T_{s-2}(x),$$

$$R_s \, (x) = (Q_{s-1}(x))R_{s-1}(x) + R_{s-2}(x),$$

et

$$Q_{s-1}(x) = R_{s-2}(x)/R_{s-1}(x),$$

où $T_s(x)$ est un polynôme de positions d'erreurs, $R_s(x)$ est un polynôme de valeurs d'erreurs et $Q_{s-1}(x)$ est un polynôme de valeurs intermédiaires,
un dispositif (6) pour la détermination de positions d'erreurs $x_k$ et de valeurs d'erreurs $Y_k$ par une recherche de positions zéros de Chien par la relation :

$$Y_k = \frac{R(X_k)}{X_k{}^b * T'(X_k)} \, ,$$

où $T'(X_k)$ est la dérivée première dans une position $x_k$, et
un dispositif (7) pour la correction de mots de données à l'intérieur d'un bloc de données codé en RS présent à l'aide des positions d'erreurs $X_k$ et des valeurs d'erreurs $Y_k$ déterminées,

caractérisé par,
dans le dispositif (3) destiné à déterminer les syndromes $(S(x))$, des générateurs de syndromes (11), constitués chacun par

- des premiers étages OU exclusif (14), aux entrées d'un desquels sont acheminés, en parallèle, les bits de mots de données des signaux de données codés en RS,
- des registres (13) pour mettre en mémoire les mots de données délivrés par les premiers étages OU exclusif (14),
- un premier multiplicateur (15) pour la multiplication des mots de données présents à la sortie du registre (13) par une constante $\alpha^i$, où i est une grandeur réglée de 0 à 15,
- un deuxième multiplicateur (16) pour la multiplication des mots de données présents à la sortie du registre (13) par une constante $\alpha^{i+120}$,
- un premier multiplexeur (17) qui, lors d'un décodage de signaux de données codés en RS suivant un polynôme générateur de code commençant avec $\alpha^0$, transmet les données pouvant être prélevées à une sortie du premier multiplicateur (15) à d'autres entrées des premiers étages OU exclusif (14) et qui, lors du décodage de signaux de données codés en RS suivant un polynôme générateur de code commençant avec $\alpha^{120}$, transmet les données pouvant être prélevées à une sortie du deuxième multiplicateur (16) aux autres entrées des étages OU exclusif (14),

dans le dispositif (6) destiné à déterminer des positions d'erreurs $X_k$ et des valeurs d'erreurs $Y_k$,

- un compteur progressif (40) pour compter les mots de données se trouvant dans un bloc de données et pour délivrer une valeur de comptage (x) lors de la détermination d'une position zéro de Chien, ainsi que chaque fois
- une première pile (44), dans laquelle les valeurs de comptage (x) délivrées par le compteur progressif (40) peuvent être inscrites,
- une deuxième pile (56), dans laquelle des données lues à la fin de chaque bloc de données dans la première pile (44) peuvent être inscrites,
- une troisième pile (45), dans laquelle les valeurs d'erreurs ($Y_k$) peuvent être inscrites en même temps que l'inscription respective des valeurs de comptage ($x_k$) dans la première pile (44),
- une quatrième pile (60), dans laquelle des données lues à la fin d'un bloc de données dans la troisième pile (45) peuvent être inscrites, et
- un compteur inverse (46) opérant parallèlement au compteur progressif (40), qui présente un décalage de $\alpha^{-120}$ par rapport au compteur progressif (40), dans le dispositif (7) destiné à la correction de mots de données, à chaque fois
- un compteur régressif (52) pour décompter, en commençant par la valeur d'une longueur de bloc de données,
- un dispositif (57) pour comparer la valeur de comptage à chaque fois présente dans une position la plus haute dans la deuxième pile (56) aux valeurs de comptage délivrées par le compteur régressif (52) pour dériver un signal de commande (Trouvé) en cas d'égalité des valeurs présentes,
- une porte ET (58), dont une entrée est connectée à une sortie du dispositif de comparaison (57),
- un deuxième compteur progressif (62) commandé par le compteur inverse (46), qui présente un décalage de 120,
- un troisième multiplicateur (61) destiné à la multiplication de la valeur d'erreur ($X_k$) présente dans une position la plus haute dans la quatrième pile par la valeur de comptage délivrée par le deuxième compteur progressif (62),
- un deuxième multiplexeur (59) qui, lors d'un décodage de signaux de données codés en RS suivant un polynôme générateur de code commençant avec $\alpha^0$, transmet la valeur d'erreur ($X_k$) présente dans une position la plus haute dans la quatrième pile (60) à une autre entrée de la porte ET (58) et qui, lors d'un décodage de signaux de données codés en RS suivant un polynôme générateur de code commençant avec $\alpha^{120}$, transfère la valeur ($Y_k$) présente à la sortie du deuxième multiplexeur (59) à l'autre entrée de la porte ET (58),
- des deuxièmes étages OU exclusif (66), aux premières entrées desquels sont acheminés, en parallèle, les bits du signal pouvant être prélevés aux sorties de la porte ET (58), aux deuxièmes entrées desquelles sont acheminés, en parallèle, les bits des mots de données adaptés au temps de transmission du signal des signaux de données codés en RS et à la sortie desquels peuvent être prélevés des mots de données corrigés.

3. Montage de circuit suivant la revendication 2, caractérisé en ce que le compteur progressif (40) présente un troisième étage multiplexeur (41) avec un deuxième registre (42) monté en aval, dans lequel, au début du bloc, la valeur $\alpha^0 = 1$ est appliquée à une entrée du troisième étage multiplexeur (41) et dans lequel, pendant le reste du temps, des valeurs, multipliées par une valeur $\alpha^j$, des valeurs de sortie délivrées par le registre (42) sont présentes à une autre entrée de l'étage multiplexeur (41).

4. Montage de circuit suivant la revendication 2, caractérisé en ce que le compteur régressif (52) présente un quatrième étage multiplexeur (53) avec un registre (54) monté en aval, dans lequel, au début du bloc, la valeur d'une longueur de bloc est appliquée à une entrée du quatrième étage multiplexeur (53) et dans lequel, pendant le reste du temps, les valeurs de sortie délivrées par le registre (54) monté en aval sont appliquées à une autre entrée du quatrième étage multiplexeur (53).

5. Montage de circuit suivant la revendication 2, caractérisé en ce que le compteur inverse (46) présente un cinquième étage multiplexeur (47) avec un autre registre (48) monté en aval, auquel est appliquée, par l'intermédiaire du cinquième étage multiplexeur (47), au début du bloc, une valeur $\alpha = -120$ et, pendant le reste du temps, une valeur qui est présente à la sortie de l'autre registre (48) monté en aval et qui est multipliée dans un étage multiplicateur (49) par $\alpha^{120}$.

6. Montage de circuit suivant les revendications 2 et 5, caractérisé en ce que l'autre compteur progressif (62) présente un quatrième étage multiplicateur (65) avec un cinquième registre (63) monté en aval, auquel est appliquée, par l'intermédiaire du quatrième étage multiplicateur (65), au début du bloc, une valeur présente à la sortie du quatrième registre (48) et, pendant le reste du temps, une valeur qui est présente à la sortie du cinquième registre (63) et qui est multipliée dans le quatrième étage multiplicateur (65) par $\alpha^{120}$.

7. Montage de circuit suivant les revendications 2 à 6, caractérisé en ce que chacun des étages multiplicateurs destinés à multiplier des valeurs par un facteur $\alpha^{i+b}$, où i = 0 à 15 et b = 120 ou 0, se présente sous la forme d'un opérateur OU exclusif.

FIG. 1

FIG.3

FIG.2

FIG.4

EP 0 545 498 B1

FIG.5

Terms for factor : $a^0$
0 = 0
1 = 1
2 = 2
3 = 3
4 = 4
5 = 5
6 = 6
7 = 7

Terms for factor : $a^1$
0 = 7
1 = 0
2 = 7 + 1
3 = 7 + 2
4 = 7 + 3
5 = 4
6 = 5
7 = 6

Terms for factor : $a^2$
0 = 6
1 = 7
2 = 6 + 0
3 = 7 + 6 + 1
4 = 7 + 6 + 2
5 = 7 + 3
6 = 4
7 = 5

Terms for factor : $a^3$
0 = 5
1 = 6
2 = 7 + 5
3 = 6 + 5 + 0
4 = 7 + 6 + 5 + 1
5 = 7 + 6 + 2
6 = 7 + 3
7 = 4

FIG. 6a$^{\text{I}}$

Terms for factor : $a^4$

```
0 =    4
1 =    5
2 =    6 +    4
3 =    7 +    5 +    4
4 =    6 +    5 +    4 +    0
5 =    7 +    6 +    5 +    1
6 =    7 +    6 +    2
7 =    7 +    3
```

Terms for factor : $a^5$

```
0 =    7 +    3
1 =    4
2 =    7 +    5 +    3
3 =    7 +    6 +    4 +    3
4 =    5 +    4 +    3
5 =    6 +    5 +    4 +    0
6 =    7 +    6 +    5 +    1
7 =    7 +    6 +    2
```

Terms for factor : $a^5$

```
0 =    7 +    6 +    2
1 =    7 +    3
2 =    7 +    6 +    4 +    2
3 =    6 +    5 +    3 +    2
4 =    4 +    3 +    2
5 =    5 +    4 +    3
6 =    6 +    5 +    4 +    0
7 =    7 +    6 +    5 +    1
```

Terms for factor : $a^7$

```
0 =    7 +    6 +    5 +    1
1 =    7 +    6 +    2
2 =    6 +    5 +    3 +    1
3 =    5 +    4 +    2 +    1
4 =    7 +    3 +    2 +    1
5 =    4 +    3 +    2
6 =    5 +    4 +    3
7 =    6 +    5 +    4 +    0
```

# FIG. 6a[II]

Terms for factor : $a^8$

0 =   6 +   5 +   4 +   0
1 =   7 +   6 +   5 +   1
2 =   7 +   5 +   4 +   2 +   0
3 =   4 +   3 +   1 +   0
4 =   6 +   2 +   1 +   0
5 =   7 +   3 +   2 +   1
6 =   4 +   3 +   2
7 =   5 +   4 +   3

Terms for factor : $a^9$

0 =   5 +   4 +   3
1 =   6 +   5 +   4 +   0
2 =   7 +   6 +   4 +   3 +   1
3 =   7 +   3 +   2 +   0
4 =   5 +   1 +   0
5 =   6 +   2 +   1 +   0
6 =   7 +   3 +   2 +   1
7 =   4 +   3 +   2

Terms for factor : $a^{10}$

0 =   4 +   3 +   2
1 =   5 +   4 +   3
2 =   6 +   5 +   3 +   2 +   0
3 =   7 +   6 +   2 +   1
4 =   7 +   4 +   0
5 =   5 +   1 +   0
6 =   6 +   2 +   1 +   0
7 =   7 +   3 +   2 +   1

Terms for factor : $a^{11}$

0 =   7 +   3 +   2 +   1
1 =   4 +   3 +   2
2 =   7 +   5 +   4 +   2 +   1
3 =   7 +   6 +   5 +   1 +   0
4 =   6 +   3
5 =   7 +   4 +   0
6 =   5 +   1 +   0
7 =   6 +   2 +   1 +   0

# FIG. 6a$^{III}$

Terms for factor : $\alpha^{12}$

| | | | | |
|---|---|---|---|---|
| 0 = | 6 + | 2 + | 1 + | 0 |
| 1 = | 7 + | 3 + | 2 + | 1 |
| 2 = | 6 + | 4 + | 3 + | 1 + 0 |
| 3 = | 7 + | 6 + | 5 + | 4 + 0 |
| 4 = | 7 + | 5 + | 2 | |
| 5 = | 6 + | 3 | | |
| 6 = | 7 + | 4 + | 0 | |
| 7 = | 5 + | 1 + | 0 | |

Terms for factor : $\alpha^{13}$

| | | | | |
|---|---|---|---|---|
| 0 = | 5 + | 1 + | 0 | |
| 1 = | 6 + | 2 + | 1 + | 0 |
| 2 = | 7 + | 5 + | 3 + | 2 + 0 |
| 3 = | 6 + | 5 + | 4 + | 3 |
| 4 = | 7 + | 6 + | 4 + | 1 |
| 5 = | 7 + | 5 + | 2 | |
| 6 = | 6 + | 3 | | |
| 7 = | 7 + | 4 + | 0 | |

Terms for factor : $\alpha^{14}$

| | | | | |
|---|---|---|---|---|
| 0 = | 7 + | 4 + | 0 | |
| 1 = | 5 + | 1 + | 0 | |
| 2 = | 7 + | 6 + | 4 + | 2 + 1 |
| 3 = | 5 + | 4 + | 3 + | 2 |
| 4 = | 7 + | 6 + | 5 + | 3 + 0 |
| 5 = | 7 + | 6 + | 4 + | 1 |
| 6 = | 7 + | 5 + | 2 | |
| 7 = | 6 + | 3 | | |

Terms for factor : $\alpha^{15}$

| | | | | |
|---|---|---|---|---|
| 0 = | 6 + | 3 | | |
| 1 = | 7 + | 4 + | 0 | |
| 2 = | 6 + | 5 + | 3 + | 1 + 0 |
| 3 = | 7 + | 4 + | 3 + | 2 + 1 |
| 4 = | 6 + | 5 + | 4 + | 2 |
| 5 = | 7 + | 6 + | 5 + | 3 + 0 |
| 6 = | 7 + | 6 + | 4 + | 1 |
| 7 = | 7 + | 5 + | 2 | |

# FIG. 6b

Terms for factor : $a^{120}$
```
0 =    5 +    4 +    3 +   0
1 =    6 +    5 +    4 +   1 +   0
2 =    7 +    6 +    4 +   3 +   2 +   1
3 =    7 +    2 +    0
4 =    5 +    4 +    1 +   0
5 =    6 +    5 +    2 +   1 +   0
6 =    7 +    6 +    3 +   2 +   1
7 =    7 +    4 +    3 +   2
```

Terms for factor : $a^{121}$
```
0 =    7 +    4 +    3 +   2
1 =    5 +    4 +    3 +   0
2 =    7 +    6 +    5 +   3 +   2 +   1 +   0
3 =    6 +    1
4 =    4 +    3 +    0
5 =    5 +    4 +    1 +   0
6 =    6 +    5 +    2 +   1 +   0
7 =    7 +    6 +    3 +   2 +   1
```

Terms for factor : $a^{122}$
```
0 =    7 +    6 +    3 +   2 +   1
1 =    7 +    4 +    3 +   2
2 =    7 +    6 +    5 +   4 +   2 +   1 +   0
3 =    5 +    0 +
4 =    7 +    3 +    2
5 =    4 +    3 +    0
6 =    5 +    4 +    1 +   0
7 =    6 +    5 +    2 +   1 +   0
```

Terms for factor : $a^{123}$
```
0 =    6 +    5 +    2 +   1 +   0
1 =    7 +    6 +    3 +   2 +   1
2 =    7 +    6 +    5 +   4 +   3 +   1 +   0
3 =    7 +    4
4 =    6 +    2 +    1
5 =    7 +    3 +    2
6 =    4 +    3 +    0
7 =    5 +    4 +    1 +   0
```

FIG. 7a'

Terms for factor : $a^{124}$
```
0 =    5 +    4 +    1 +   0
1 =    6 +    5 +    2 +   1 +   0
2 =    7 +    6 +    5 +   4 +   3 +   2 +    0
3 =    7 +    6 +    3
4 =    7 +    5 +    1 +   0
5 =    6 +    2 +    1
6 =    7 +    3 +    2
7 =    4 +    3 +    0
```

Terms for factor : $a^{125}$
```
0 =    4 +    3 +    0
1 =    5 +    4 +    1 +   0
2 =    6 +    5 +    4 +   3 +   2 +   1
3 =    7 +    6 +    5 +   2
4 =    7 +    6 +    4 +   0
5 =    7 +    5 +    1 +   0
6 =    6 +    2 +    1
7 =    7 +    3 +    2
```

Terms for factor : $a^{126}$
```
0 =    7 +    3 +    2
1 =    4 +    3 +    0
2 =    7 +    5 +    4 +   3 +   2 +   1 +    0
3 =    7 +    6 +    5 +   4 +   1
4 =    6 +    5 +    3
5 =    7 +    6 +    4 +   0
6 =    7 +    5 +    1 +   0
7 =    6 +    2 +    1
```

Terms for factor : $a^{127}$
```
0 =    6 +    2 +    1
1 =    7 +    3 +    2
2 =    6 +    4 +    3 +   2 +   1 +   0
3 =    7 +    6 +    5 +   4 +   3 +   0
4 =    7 +    5 +    4 +   2
5 =    6 +    5 +    3
6 =    7 +    6 +    4 +   0
7 =    7 +    5 +    1 +   0
```

FIG. 7a$^{II}$

Terms for factor : $a^{128}$

```
0 =    7 +    5 +    1 +   0
1 =    6 +    2 +    1
2 =    5 +    3 +    2 +   1 +   0
3 =    7 +    6 +    5 +   4 +   3 +   2
4 =    6 +    4 +    3 +   1
5 =    7 +    5 +    4 +   2
6 =    6 +    5 +    3
7 =    7 +    6 +    4 +   0
```

Terms for factor : $a^{129}$

```
0 =    7 +    6 +    4 +   0
1 =    7 +    5 +    1 +   0
2 =    7 +    4 +    2 +   1 +   0
3 =    7 +    6 +    5 +   4 +   3 +   2 +   1
4 =    5 +    3 +    2 +   0
5 =    6 +    4 +    3 +   1
6 =    7 +    5 +    4 +   2
7 =    6 +    5 +    3
```

Terms for factor : $a^{130}$

```
0 =    6 +    5 +    3
1 =    7 +    6 +    4 +   0
2 =    7 +    6 +    3 +   1 +   0
3 =    7 +    6 +    5 +   4 +   3 +   2 +   1 + 0
4 =    7 +    4 +    2 +   1
5 =    5 +    3 +    2 +   0
6 =    6 +    4 +    3 +   1
7 =    7 +    5 +    4 +   2
```

Terms for factor : $a^{131}$

```
0 =    7 +    5 +    4 +   2
1 =    6 +    5 +    3
2 =    6 +    5 +    2 +   0
3 =    6 +    5 +    4 +   3 +   2 +   1 +   0
4 =    6 +    3 +    1 +   0
5 =    7 +    4 +    2 +   1
6 =    5 +    3 +    2 +   0
7 =    6 +    4 +    3 +   1
```

FIG. 7a$^{\text{III}}$

Terms for factor : $a^{132}$

| | | | | | | | |
|---|---|---|---|---|---|---|---|
| 0 = | 6 + | 4 + | 3 + | 1 | | | |
| 1 = | 7 + | 5 + | 4 + | 2 | | | |
| 2 = | 5 + | 4 + | 1 | | | | |
| 3 = | 5 + | 4 + | 3 + | 2 + | 1 + | 0 | |
| 4 = | 5 + | 2 + | 0 | | | | |
| 5 = | 6 + | 3 + | 1 + | 0 | | | |
| 6 = | 7 + | 4 + | 2 + | 1 | | | |
| 7 = | 5 + | 3 + | 2 + | 0 | | | |

Terms for factor : $a^{133}$

| | | | | | |
|---|---|---|---|---|---|
| 0 = | 5 + | 3 + | 2 + | 0 | |
| 1 = | 6 + | 4 + | 3 + | 1 | |
| 2 = | 7 + | 4 + | 3 + | 0 | |
| 3 = | 4 + | 3 + | 2 + | 1 + | 0 |
| 4 = | 4 + | 1 | | | |
| 5 = | 5 + | 2 + | 0 | | |
| 6 = | 6 + | 3 + | 1 + | 0 | |
| 7 = | 7 + | 4 + | 2 + | 1 | |

Terms for factor : $a^{134}$

| | | | | |
|---|---|---|---|---|
| 0 = | 7 + | 4 + | 2 + | 1 |
| 1 = | 5 + | 3 + | 2 + | 0 |
| 2 = | 7 + | 6 + | 3 + | 2 |
| 3 = | 3 + | 2 + | 1 + | 0 |
| 4 = | 7 + | 3 + | 0 | |
| 5 = | 4 + | 1 | | |
| 6 = | 5 + | 2 + | 0 | |
| 7 = | 6 + | 3 + | 1 + | 0 |

Terms for factor : $a^{135}$

| | | | | |
|---|---|---|---|---|
| 0 = | 6 + | 3 + | 1 + | 0 |
| 1 = | 7 + | 4 + | 2 + | 1 |
| 2 = | 6 + | 5 + | 2 + | 1 |
| 3 = | 7 + | 2 + | 1 + | 0 |
| 4 = | 6 + | 2 | | |
| 5 = | 7 + | 3 + | 0 | |
| 6 = | 4 + | 1 | | |
| 7 = | 5 + | 2 + | 0 | |

# FIG. 7b